(19) Europäisches Patentamt
European Patent Office
Office européen des brevets

(11) Veröffentlichungsnummer: **0 026 310**
**B1**

(12) 

# EUROPÄISCHE PATENTSCHRIFT

(45) Veröffentlichungstag der Patentschrift: **27.07.83**

(51) Int. Cl.³: **C 08 L 61/04,** C 08 K 5/00

(21) Anmeldenummer: **80104867.9**

(22) Anmeldetag: **16.08.80**

(54) **Brandschutzausrüstung für Resolharz-Schichtpressstoffe.**

(30) Priorität: **29.08.79 DE 2934864**

(43) Veröffentlichungstag der Anmeldung: **08.04.81 Patentblatt 81/14**

(45) Bekanntmachung des Hinweises auf die Patenterteilung: **27.07.83 Patentblatt 83/30**

(84) Benannte Vertragsstaaten: **AT FR GB IT SE**

(56) Entgegenhaltungen:
**DE-A-2 721 889**
**CHEMICAL ABSTRACTS, Band 89, Nr. 22, November 1978, Seite 45, Zusammenfassung Nr. 180995x, Columbus, Ohio, USA.**

(73) Patentinhaber: **Chemische Fabrik Kalk GmbH, Kalker Hauptstrasse 22 Postfach 91 01 57, D-5000 Köln 91 (DE)**

(72) Erfinder: **Freitag, Friedrich, Am Zuckerberg 55, D-5000 Köln 50 (DE)**
Erfinder: **Kerscher,Utto, Dr. Dipl. Chem., Am Beissel 25, D-5042 Erftstadt 12 (DE)**

**EP 0 026 310 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

Brandschutzausrüstung für Resolharz-Schichtpreßstoffe

Schichtpreßstoffe sind Materialien, die in großen Mengen Phenol-Resolharze oder Kresol-Resolharze enthalten, mit denen Papiere, Glasgewebe oder Textilgewebe getränkt und getrocknet werden, wonach mehrere Lagen solcher getrockneter Schichten übereinandergelegt und unter Anwendung von Hitze und Druck zu Schichtpreßstoffen ausgehärtet werden. Derartige Werkstoffe finden, insbesondere mit Kupferfolien kaschiert, als gedruckte Schaltungen Verwendung beim Bau von Fernmelde- und anderen elektronischen Geräten. Dabei ist es vielfach erforderlich, um eine Brandgefährdung durch solche Geräte, beispielsweise bei Kurzschluß oder Funkenbildung, zu vermeiden, die dazu verwendeten Schichtpreßstoffe brandwidrig auszurüsten.

Es ist auch bereits bekannt, zur Brandschutzausrüstung von Resolharz-Schichtpreßstoffen den Resolharzlösungen vor dem Aushärten Pentabromdiphenyläther als Brandschutzkomponente zuzusetzen. Die damit erzielte Brandwidrigkeit reicht jedoch nicht aus, nach der Brandnorm UL 94 die Bedingungen der Brandklasse V-O zu erfüllen.

Damit war die Aufgabe gegeben, ein Verfahren zur Brandschutzausrüstung von Resolharz-Schichtpreßstoffen zu finden, durch das eine so weitgehende Brandwidrigkeit bewirkt werden kann, wie sie beispielsweise der Brandklasse V-O der Brandnorm UL 94 entspricht.

Gegenstand der vorliegenden Erfindung ist danach ein Verfahren zur Brandschutzausrüstung von Resolharz-Schichtpreßstoffen durch Zugabe von organischen Bromverbindungen zu den Harzlösungen. Das Verfahren zeichnet sich dadurch aus, daß organische Bromverbindungen, die das Brom zugleich in aromatischer und in aliphatischer Bindung enthalten oder die ein Gemisch aus aromatischen und aus aliphatischen oder cycloaliphatischen Bromverbindungen sind, zusammen mit einem Arylalkarylphosphat zugesetzt werden.

Als Verbindungen, die gleichzeitig aromatisch und aliphatisch gebundenes Brom enthalten, sind solche der allgemeinen Formel

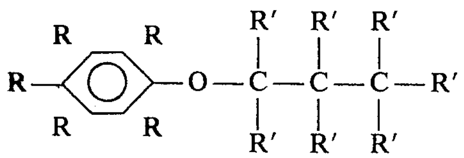

zu nennen, in der mindestens 2 R und 2 R′ jeweils ein Bromatom und die restlichen R und R′ je ein Wasserstoff- oder Chloratom oder einen kurzkettigen Alkylrest mit 1 bis 3 C-Atomen bedeuten. Daneben kann R′ auch eine Hydroxyl- oder eine Alkoxygruppe sein. Beispiele für solche Verbindungen sind:

2,4,6-Tribromphenoxy-2,3-dibrom-2-methylpropan,
2,6-Dibrom-4-methylphenoxy-2,3-dibrompropan,
2,3,4,5,6-Pentabromphenoxy-2,3-dibrom-2-chlormethylpropan,
2,4,6-Tribromphenoxy-2,3-dibrom-1-hydroxy-propan,
2,3,5-Tribrom-4-methyl-5-methoxy-phenoxy-2,3-dibrompropan.

Anstelle dieser Verbindungen können erfindungsgemäß auch Gemische eingesetzt werden, die aromatische Bromverbindungen und aliphatische oder cycloaliphatische Bromverbindungen enthalten.

Als weitere Komponente wird den Harzlösungen erfindungsgemäß ein Arylalkarylphosphat zugesetzt. Unter diesen findet insbesondere Diphenylkresylphosphat Verwendung. Dabei ist es vorteilhaft, die aromatisch-aliphatische Bromverbindung oder die Kombination dieser Verbindungen zunächst mit dem Arylalkarylphosphat zu vermischen und dann das Gemisch der Harzlösung zuzusetzen, mit der dann die Trägerstoffe, wie Papiere oder Gewebe, getränkt werden. Dazu werden einer Lösung aus 50 Gewichtsteilen Resolharz in 50 Gewichtsteilen eines geeigneten Lösungsmittels, beispielsweise einem Gemisch aus gleichen Raumteilen Aceton und Isopropanol, 7 bis 20 Gewichtsteile eines Arylalkarylphosphats sowie 16 bis 23 Gewichtsteile einer organischen Bromverbindung mit aromatisch und aliphatisch gebundenem Brom oder 7 bis 20 Gewichtsteile einer organischen Bromverbindung mit aromatisch gebundenem Brom und 3 bis 7 Gewichtsteile einer organischen Bromverbindung mit aliphatisch oder cycloaliphatisch gebundenem Brom zugegeben.

Die Gemische aus Arylalkarylphosphat und einer oder mehreren organischen Bromverbindungen zeigen eine Viskosität unter 500 mPa s und sind somit leicht zu gießen oder zu pumpen. Besonders bewährt hat sich ein Gemisch aus etwa 42,5 Gew.-% Pentabromdiphenyläther, 16,0 Gew.-% Hexabromcyclododecan und 41,5 Gew.-% Diphenylkresylphosphat.

Zur Herstellung der erfindungsgemäß brandwidrig einzustellenden Phenolharzlaminate wird zunächst in an sich bekannter Weise das Resolharz in Lösung gebracht. Dieser Lösung wird dann das Gemisch aus einer aromatisch-aliphatischen Bromverbindung mit einem Arylalkarylphosphat oder ein

Gemisch aus einer aromatischen Bromverbindung, einer aliphatischen oder cycloaliphatischen Bromverbindung und einem Arylalkarylphosphat zugegeben. Mit diesem Gemisch werden Papier- oder Gewebebahnen imprägniert und die Bahnen bei einer Temperatur von etwa 100°C getrocknet, wobei gleichzeitig eine weitere Kondensation des Resolharzes eintritt. Die getrockneten Bahnen werden in Abschnitte entsprechender Größe zerschnitten, zu Stapeln von gewünschter Dicke übereinandergelegt und in Etagenpressen bei Temperaturen zwischen 160 und 170°C verpreßt und zugleich ausgehärtet.

Die dabei entstehenden Schichtpreßstoffe zeigen bei sehr guter Brandwidrigkeit nur wenig veränderte elektrische oder sonstige Eigenschaften, wie die nachfolgenden Tabellen zeigen, in denen die Probe 1 ein nicht brandwidrig eingestelltes und die Probe 2 ein nicht erfindungsgemäßes Kresolharz darstellen.

Tabelle 1

| | Probe 1 | 2 | 3 | 4 | 5 |
|---|---|---|---|---|---|
| | (Gewichtsteile) | | | | |
| Imprägnierlösung | | | | | |
| Modifiziertes Kresol-Resolharz, 50%ig in Aceton-Isopropanol 1 : 1 | 100,0 | 100,0 | 100,0 | 100,0 | 100,0 |
| Pentabromdiphenyläther | – | 19,5 | 13,8 | – | – |
| Hexabromcyclododecan | – | – | 5,2 | – | – |
| 2,4,6-Tribromphenoxy-2,3-dibrom-2-methylpropan | – | – | – | 19,5 | – |
| 2,6-Dibrom-4-methylphenoxy-2,3-dibrompropan | – | – | – | – | 19,5 |
| Diphenylkresylphosphat | – | 13,0 | 13,5 | 13,0 | 13,0 |
| Schichtpreßstoff-Zusammensetzung | (Gewichtsteile) | | | | |
| Baumwollpapier | 50,0 | 50,0 | 50,0 | 50,0 | 50,0 |
| Modifiziertes Kresol-Resolharz | 50,0 | 50,0 | 50,0 | 50,0 | 50,0 |
| Pentabromdiphenyläther | – | 19,5 | 13,8 | – | – |
| Hexabromcyclododecan | – | – | 5,2 | – | – |
| 2,4,6-Tribromphenoxy-2,3-dibrom-2-methylpropan | – | – | – | 19,5 | – |
| 2,6-Dibrom-4-methylphenoxy-2,3-dibrompropan | – | – | – | – | 19,5 |
| Diphenylkresylphosphat | – | 13,0 | 13,5 | 13,0 | 13,0 |

Tabelle 2

| | Probe 1 | 2 | 3 | 4 | 5 |
|---|---|---|---|---|---|
| Brandverhalten nach UL 94 | | | | | |
| V-2 Selbstverlöschung <25 sec. Material tropft brennend ab ∅ sec. | 25 | – | – | – | – |
| V-1 Selbstverlöschung <25 sec. Material tropft nicht brennend ab ∅ sec. | – | 9 | – | – | – |
| V-0 Selbstverlöschung <5 sec. Material tropft nicht brennend ab ∅ sec. | – | – | 2 | 4 | 3 |
| Eigenschaften | | | | | |
| Kriechstromfestigkeit DIN 53 480 1,5 mm Platten, Verfahren KA, Stufe | 2 | 2 | 2 | 2 | 2 |
| Durchschlagsspannung DIN 53 481 bei 1,5 mm Platten, kV | 18,5 | 18,3 | 18,3 | 18,0 | 17,9 |
| Stanzbarkeit DIN 53 488 bei 23°C, Kennwert | 1,2 bis 2,6 | 1,9 bis 2,4 | 2,1 bis 2,5 | 1,9 bis 2,4 | 1,9 bis 2,6 |

## Patentansprüche

1. Verfahren zur Brandschutzausrüstung von Resolharzschichtpreßstoffen durch Zugabe von organischen Brom- und Phosphorverbindungen zu den Harzlösungen, dadurch gekennzeichnet, daß organische Bromverbindungen, die das Brom zugleich in aromatischer und in aliphatischer Bindung enthalten oder die ein Gemisch aus aromatischen und aus aliphatischen oder cycloaliphatischen Bromverbindungen sind, zusammen mit einem Arylalkarylphosphat zugesetzt werden.

2. Verfahren nach Anspruch 1, dadurch gekennzeichnet, daß einer Lösung aus 50 Gewichtsteilen Resolharz in 50 Gewichtsteilen Lösungsmittel 7 bis 20 Gewichtsteile eines Arylalkarylphosphats sowie 16 bis 23 Gewichtsteile einer organischen Bromverbindung mit aromatisch und aliphatisch gebundenem Brom oder 7 bis 20 Gewichtsteile einer organischen Bromverbindung mit aromatisch gebundenem Brom und 3 bis 7 Gewichtsteile einer organischen Bromverbindung mit aliphatisch oder cycloaliphatisch gebundenem Brom zugegeben werden.

## Claims

1. Process for fire-protection finishing of resol-type resinous laminates by adding organic bromine and phosphorous compounds to the resin solutions and characterized by the fact that organic bromine compounds, which simultaneously contain aromatically and aliphatically bonded bromine or are a mixture of aromatic and aliphatic or cycloaliphatic bromine compounds, are added together with an arylalkarylphosphate.

2. Process according to claim 1 and characterized by the fact that 7 to 20 parts by weight of an arylalkarylphosphate as well as 16 to 23 parts by weight of an organic bromine compound with aromatically and aliphatically bonded bromine or 7 to 20 parts by weight of an organic bromine compound with aromatically bonded bromine and 3 to 7 parts by weight of an organic bromine compound with aliphatically or cycloaliphatically bonded bromine are added to a solution of 50 parts by weight of resol-type resin in 50 parts by weight of solvent.

**Revendications**

1. Procédé d'ignifugation de laminés à base de résines phénoliques de type résol par addition de composés organiques du brome et du phosphore dans les solutions de résine, caractérisé en ce que des composés organiques du brome, contenant le brome à la fois en liaison aromatique et en liaison aliphatique ou constitués d'un mélange de composés aromatiques et de composés aliphatiques ou cycloaliphatiques du brome, sont additionnés en même temps qu'un phosphate d'aryle et d'alkaryle.

2. Procédé suivant la revendication 1, caractérisé en ce qu'on additionne à une solution de 50 parties en poids de résine phénolique de type résol dans 50 parties en poids d'un solvant, 7 à 20 parties en poids d'un phosphate d'aryle et d'alkaryle ainsi que 16 à 23 parties en poids d'un composé organique du brome contenant le brome en liaison aromatique et en liaison aliphatique ou 7 à 20 parties en poids d'un composé organique du brome contenant le brome en liaison aromatique et 3 à 7 parties en poids d'un composé organique du brome contenant le brome en liaison aliphatique ou cycloaliphatique.